(19) Europäisches Patentamt / European Patent Office / Office européen des brevets

(11) **EP 4 159 433 A1**

(12) **EUROPEAN PATENT APPLICATION**
published in accordance with Art. 153(4) EPC

(43) Date of publication:
**05.04.2023 Bulletin 2023/14**

(21) Application number: **21812243.0**

(22) Date of filing: **27.05.2021**

(51) International Patent Classification (IPC):
$B32B\ 27/00^{(2006.01)}$    $B32B\ 27/20^{(2006.01)}$
$H01L\ 23/36^{(2006.01)}$    $H01L\ 23/373^{(2006.01)}$
$C08L\ 83/05^{(2006.01)}$    $C08L\ 83/07^{(2006.01)}$
$C08J\ 5/18^{(2006.01)}$    $B29C\ 43/20^{(2006.01)}$
$B29C\ 43/34^{(2006.01)}$    $C08K\ 3/01^{(2018.01)}$
$B32B\ 7/027^{(2019.01)}$    $H05K\ 7/20^{(2006.01)}$

(52) Cooperative Patent Classification (CPC):
**B29C 43/20; B29C 43/34; B32B 7/027;**
**B32B 27/00; B32B 27/20; C08J 5/18; C08K 3/01;**
**C08L 83/04; H01L 23/36; H01L 23/373; H05K 7/20**

(86) International application number:
**PCT/JP2021/020298**

(87) International publication number:
**WO 2021/241715 (02.12.2021 Gazette 2021/48)**

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(30) Priority: **29.05.2020 JP 2020094786**
        **25.11.2020 JP 2020195370**

(71) Applicant: **Sekisui Polymatech Co., Ltd.**
**Saitama-city, Saitama 338-0837 (JP)**

(72) Inventors:
- **UMETANI, Hiroshi**
  **Saitama-city, Saitama 338-0837 (JP)**
- **KUDOH, Hiroki**
  **Saitama-city, Saitama 338-0837 (JP)**

(74) Representative: **Ter Meer Steinmeister & Partner**
**Patentanwälte mbB**
**Nymphenburger Straße 4**
**80335 München (DE)**

(54) **METHOD FOR PRODUCING THERMALLY CONDUCTIVE SHEET AND MULTILAYER BODY**

(57) The method for producing a thermally conductive sheet according to the present invention comprises: a step (1) of obtaining a liquid composition comprising a curable silicone composition including an alkenyl group-containing organopolysiloxane and a hydrogen organopolysiloxane, a thermally conductive filler, and a volatile compound; a step (2) of sandwiching the liquid composition between two resin sheets at least one of which is a gas-permeable film and pressurizing these to obtain a sheet-shaped formed product; and a step (3) of heating the sheet-shaped formed product to volatilize at least a part of the volatile compound. According to the present invention, it is possible to provide a method for producing a thermally conductive sheet having a good sheet condition and a low thermal resistance value.

**Description**

Technical Field

The present invention relates to a method for producing a thermally conductive sheet and a laminated body.

Background Art

In an electronic device such as a computer, an automotive part, or a cellphone, a heat-dissipating element such as a heat sink is generally used in order to dissipate heat generated from a heating element such as a semiconductor element or a machine part. It is known that a thermally conductive sheet is disposed between a heating element and a heat-dissipating element for the purpose of increasing the efficiency of heat transfer to the heat-dissipating element. The thermally conductive sheet is generally used by being compressed when disposed inside an electronic device, and because of this, high softness is required, and further in order to enhance the heat-dissipating property, it is necessary to increase the thermal conductivity.

Patent Literature 1 discloses an invention relating to "a thermally conductive composition in which a thermally conductive filler is contained in a polymer matrix, the composition comprising a methyl phenyl silicone, wherein the thermally conductive filler has an average particle size of 10 to 100 $\mu$m, the content of the thermally conductive filler in the thermally conductive composition is 70% to 90% by volume, and 30% to 80% by volume of the thermally conductive filler has a particle size of 40 $\mu$m or more." Patent Literature 1 also discloses that the thermally conductive composition and the thermally conductive formed product do not provide impaired softness or bendability and are excellent in handleability and thermally conductive property.

Citation List

Patent Literature

PTL1: WO 2019/150944

Summary of Invention

Technical Problem

However, if the amount of the thermally conductive filler used for filling is increased in order to increase the thermal conductivity, the viscosity of the composition for forming a thermally conductive resin sheet increases, making sheet formation difficult. Specifically, for example, the following problems may occur: an air bubble is mixed in to cause poor curing, and an air bubble between the composition and the release film causes a poor surface condition. In addition, if the speed of sheet formation is increased in order to enhance the productivity, for example, the following problems may occur: a crack appears in the thermally conductive sheet and the air bubble is more easily mixed in.

On the other hand, a method for adding a volatile compound to adjust the viscosity of the composition to form a sheet is also conceivable. In general, a thermally conductive sheet highly filled with a thermally conductive filler is produced by sandwiching a composition as a raw material between two resin sheets and adjusting the thickness using a roll, a press, or the like, and it has been found that when a composition containing a volatile compound is used, many air bubbles are generated in the sheet by the influence of the volatile compound to cause a poor surface condition, and as a result, the thermal resistance value is likely to increase.

Therefore, an object of the present invention is to provide a method for producing a thermally conductive sheet having a good sheet condition and a low thermal resistance value even when the sheet is highly filled with a thermally conductive filler, and a laminated body including the thermally conductive sheet.

Solution to Problem

The present inventor has carried out diligent studies and as a result, found that a thermally conductive sheet produced by heating a sheet-shaped formed product obtained by sandwiching a specific liquid composition including a volatile compound between two resin sheets at least one of which is a gas-permeable film and pressurizing these, to volatilize at least a part of the volatile compound has a good sheet condition and a low thermal resistance value, and completed the present invention.

That is, the present invention provides the following [1] to [8].

[1] A method for producing a thermally conductive sheet, comprising: a step (1) of obtaining a liquid composition comprising a curable silicone composition comprising an alkenyl group-containing organopolysiloxane and a hydrogen organopolysiloxane, a thermally conductive filler, and a volatile compound; a step (2) of sandwiching the liquid composition between two resin sheets at least one of which is a gas-permeable film and pressurizing these to obtain a sheet-shaped formed product; and a step (3) of heating the sheet-shaped formed product to volatilize at least a part of the volatile compound.

[2] The method for producing a thermally conductive sheet according to the above [1], wherein in the liquid composition, a puncture load measured by inserting a puncture rod having a puncture surface having a diameter of 3 mm from a liquid level to a depth of 12 mm is 1 to 20 gf.

[3] The method for producing a thermally conductive sheet according to the above [1] or [2], wherein the gas-permeable film is a non-porous gas-permeable film.

[4] A method for producing a laminated body, wherein by a step (1) of obtaining a liquid composition comprising a curable silicone composition comprising an alkenyl group-containing organopolysiloxane and a hydrogen organopolysiloxane, a thermally conductive filler, and a volatile compound, a step (2) of sandwiching the liquid composition between two resin sheets at least one of which is a gas-permeable film and pressurizing these to obtain a sheet-shaped formed product, and a step (3) of heating the sheet-shaped formed product to volatilize at least a part of the volatile compound, a thermally conductive sheet sandwiched between the two resin sheets at least one of which is a gas-permeable film is obtained, and then a step (4) of peeling off the gas-permeable film of the thermally conductive sheet and a step (5) of laminating a low gas-permeable film on a side from which the gas-permeable film has been peeled off are carried out.

[5] A method for producing a laminated body, wherein by a step (1) of obtaining a liquid composition comprising a curable silicone composition comprising an alkenyl group-containing organopolysiloxane and a hydrogen organopolysiloxane, a thermally conductive filler, and a volatile compound, a step (2) of sandwiching the liquid composition between two resin sheets at least one of which is a gas-permeable film and pressurizing these to obtain a sheet-shaped formed product, and a step (3) of heating the sheet-shaped formed product to volatilize at least a part of the volatile compound, a thermally conductive sheet sandwiched between the two resin sheets at least one of which is a gas-permeable film is obtained, and then a step (5') of laminating a low gas-permeable film on the gas-permeable film is carried out.

[6] A laminated body comprising: a thermally conductive sheet comprising a binder which is a crosslinked product of an organopolysiloxane, a thermally conductive filler dispersed in the binder, and a volatile compound; and resin sheets provided on both sides of the thermally conductive sheet.

[7] The laminated body according to the above [6], wherein of the resin sheets provided on both sides of the thermally conductive sheet, the resin sheet provided on at least one side is a gas-permeable film.

[8] The laminated body according to the above [6], wherein the resin sheets provided on both sides of the thermally conductive sheet are both low gas-permeable films.

Advantageous Effects of Invention

According to the present invention, it is possible to provide a method for producing a thermally conductive sheet having a good sheet condition and a low thermal resistance value, and a laminated body including the thermally conductive sheet.

Brief Description of Drawing

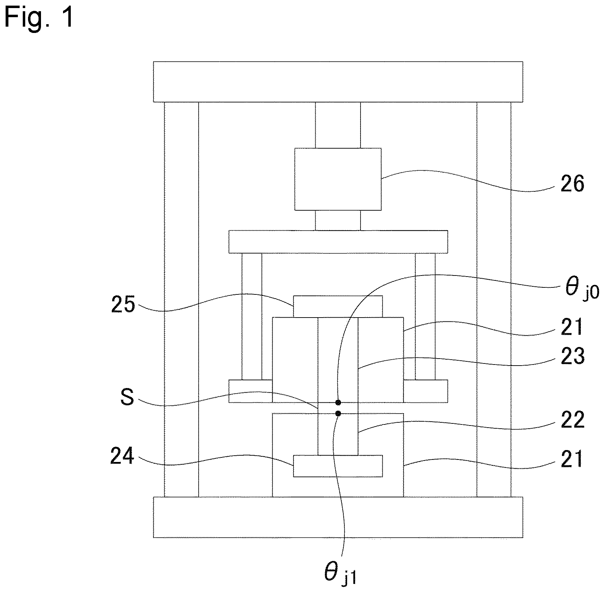

[Fig. 1] Fig. 1 is a schematic diagram of a thermal resistance measuring instrument.

Description of Embodiments

[Method for producing thermally conductive sheet]

The method for producing a thermally conductive sheet according to the present invention is a method for producing a thermally conductive sheet, including: a step (1) of obtaining a liquid composition including a curable silicone composition including an alkenyl group-containing organopolysiloxane and a hydrogen organopolysiloxane, a thermally conductive filler, and a volatile compound; a step (2) of sandwiching the liquid composition between two resin sheets at least one of which is a gas-permeable film and pressurizing these to obtain a sheet-shaped formed product; and a step (3) of heating the sheet-shaped formed product to volatilize at least a part of the volatile compound.

<Step (1)>

The step (1) is a step of obtaining a liquid composition including a curable silicone composition including an alkenyl group-containing organopolysiloxane and a hydrogen organopolysiloxane, a thermally conductive filler, and a volatile compound.

(Curable silicone composition)

The curable silicone composition includes an alkenyl group-containing organopolysiloxane as a base resin and a hydrogen organopolysiloxane as a curing agent for curing the base resin.

Specific examples of the alkenyl group-containing organopolysiloxane include a vinyl-both terminated organopolysiloxane such as vinyl-both terminated polydimethylsiloxane, vinyl-both terminated polyphenylmethylsiloxane, a vinyl-both terminated dimethylsiloxane-diphenylsiloxane copolymer, a vinyl-both terminated dimethylsiloxane-phenylmethylsiloxane copolymer, or a vinyl-both terminated dimethylsiloxane-diethylsiloxane copolymer.

The hydrogen organopolysiloxane is a compound having two or more hydrosilyl groups (SiH), and can cure an alkenyl group-containing organopolysiloxane as a base resin.

The hardness of the thermally conductive sheet can be adjusted by appropriately adjusting the ratio of the amount of the hydrogen organopolysiloxane blended to the amount of the alkenyl group-containing organopolysiloxane. Specifically, the hardness of the thermally conductive sheet can be lowered by reducing the ratio of the amount of the hydrogen organopolysiloxane blended to the amount of the alkenyl group-containing organopolysiloxane.

The content of the curable silicone composition is preferably 3 to 30% by volume, more preferably 4 to 20% by volume, and further preferably 5 to 15% by volume, based on the total amount of the liquid composition. When the content of the curable silicone composition is equal to or more than these lower limit values, it becomes easier to form a liquid composition into a sheet, and when the content is equal to or less than these upper limit values, the content of the thermally conductive filler can be increased, and the thermal resistance value of the thermally conductive sheet obtained can be reduced.

(Thermally conductive filler)

The liquid composition in the present invention contains a thermally conductive filler. By containing a thermally conductive filler, the heat-dissipating property of the thermally conductive sheet can be enhanced.

The thermally conductive filler may be a non-anisotropic filler or an anisotropic filler.

The non-anisotropic filler has an aspect ratio of 2 or less and preferably 1.5 or less. In addition, by setting the aspect ratio to 2 or less, it is possible to prevent the viscosity of the liquid composition from increasing to achieve high filling.

Specific examples of the non-anisotropic filler include a metal, a metal oxide, a metal nitride, a metal hydroxide, a carbon material, and a non-metal oxide, nitride, and carbide. In addition, examples of the shape of the non-anisotropic filler include a spherical or irregular powder.

In the non-anisotropic filler, examples of the metal include aluminum, copper, and nickel, examples of the metal oxide include aluminum oxide, magnesium oxide, and zinc oxide, and examples of the metal nitride include aluminum nitride. Examples of the metal hydroxide include aluminum hydroxide. Further, examples of the carbon material include spheroidal graphite. Examples of the non-metal oxide, nitride, and carbide include quartz, boron nitride, and silicon carbide.

Among these, aluminum oxide, aluminum nitride, and the like are preferable.

As the non-anisotropic filler, one of those described above may be used alone or two or more may be used in combination.

The average particle size of the non-anisotropic filler is preferably 0.1 to 100 $\mu$m and more preferably 0.3 to 90 $\mu$m. By setting the average particle size to 0.1 $\mu$m or more, the specific surface area of the non-anisotropic filler does not become larger than necessary, and the viscosity of the liquid composition is less likely to increase even if the non-anisotropic filler is blended in a large amount, to facilitate high filling with the non-anisotropic filler.

In addition, from the viewpoint of increasing the amount of the non-anisotropic filler used for filling, it is preferable to use two or more non-anisotropic fillers having different particle sizes in combination.

The average particle size of the non-anisotropic filler can be measured by observation using an electron microscope or the like. More specifically, the particle sizes of 50 non-arbitrary anisotropic fillers are measured using an electron microscope, an optical microscope, or an X-ray CT apparatus, and the average value (arithmetic average value) thereof can be used as the average particle size.

The anisotropic filler is a filler that has anisotropy in shape and can be oriented. The anisotropic filler is preferably at least one selected from the group consisting of a fibrous material and a flaky material. The anisotropic filler generally has a high aspect ratio and has an aspect ratio of more than 2, and one having an aspect ratio of 5 or more can also be used.

Specific examples of the anisotropic filler include a carbon-based material typified by a carbon fiber or a flaky carbon powder, a metal material typified by a metal fiber and a metal oxide, boron nitride and a metal nitride, a metal carbide, a metal hydroxide, and a polyparaphenylene benzoxazole fiber.

The content of the thermally conductive filler is preferably in the range of 500 to 6000 parts by mass, more preferably in the range of 1500 to 5000 parts by mass, and further preferably in the range of 2500 to 4500 parts by mass per 100 parts by mass of the curable silicone composition. When the amount of the thermally conductive filler is equal to or more than these lower limit values, the thermal resistance value of the thermally conductive sheet decreases and the heat-dissipating property increases, and when the amount of the thermally conductive filler is equal to or less than these upper limit values, the viscosity of the liquid composition decreases, it is easy to form a sheet, and it becomes easy to obtain a thermally conductive sheet having a good surface condition.

(Volatile compound)

The liquid composition contains a volatile compound in addition to a curable silicone composition and a thermally conductive filler. By using a liquid composition containing a volatile compound, it is possible to form a sheet using a liquid composition having a higher content of a thermally conductive filler than conventionally.

As used herein, the volatile compound means a compound having at least either one of the following properties: the temperature T1 at which the weight loss when the temperature is raised under a condition of 2°C/min in thermogravimetric analysis is 90% is in the range of 70 to 300°C, and the boiling point (1 atm) is in the range of 60 to 200°C. Here, the temperature T1 at which the weight loss is 90% means the temperature at which when the weight of a sample before thermogravimetric analysis is 100%, the weight is reduced by 90% (that is, the temperature at which the weight is 10% of the weight before measurement).

Examples of the volatile compound include a volatile silane compound and a volatile solvent, and among these, a volatile silane compound is preferable.

Examples of the volatile silane compound include an alkoxysilane compound. The alkoxysilane compound is a compound having a structure in which 1 to 3 of the four bonds of the silicon atom (Si) are bonded to alkoxy groups and the remaining bond(s) is(are) bonded to an organic substituent. Examples of the alkoxy group of the alkoxysilane compound include a methoxy group, an ethoxy group, a propoxy group, a butoxy group, a pentoxy group, and a hexatoxy group. The alkoxysilane compound may be contained as a dimer.

Among the alkoxysilane compounds, an alkoxysilane compound having a methoxy group or an ethoxy group is preferable from the viewpoint of easy availability. The number of alkoxy groups of the alkoxysilane compound is preferably 3 from the viewpoint of enhancing the affinity for the thermally conductive filler as an inorganic substance. The alkoxysilane compound is more preferably at least one selected from the group consisting of a trimethoxysilane compound and a triethoxysilane compound.

Examples of a functional group included in the organic substituent of the alkoxysilane compound include an acryloyl group, an alkyl group, a carboxyl group, a vinyl group, a methacryloyl group, an aromatic group, an amino group, an isocyanate group, an isocyanurate group, an epoxy group, a hydroxyl group, and a mercapto group. Here, when an addition-reaction type organopolysiloxane including a platinum catalyst is used as a precursor of the above matrix, it is preferable to select and use an alkoxysilane compound that is unlikely to affect the curing reaction of the organopolysiloxane forming the matrix. Specifically, when an addition-reaction type organopolysiloxane including a platinum catalyst is used, the organic substituent of the alkoxysilane compound preferably does not include an amino group, an isocyanate group, an isocyanurate group, a hydroxyl group, or a mercapto group.

The alkoxysilane compound facilitates high filling with the thermally conductive filler by enhancing the dispersibility of the thermally conductive filler, and thus it is preferable to include an alkylalkoxysilane compound having an alkyl group bonded to a silicon atom, that is, an alkoxysilane compound having an alkyl group as an organic substituent. The number of carbon atoms of the alkyl group bonded to the silicon atom is preferably 4 or more. In addition, the number of carbon atoms of the alkyl group bonded to the silicon atom is preferably 16 or less from the viewpoint of causing the viscosity of the alkoxysilane compound itself to be relatively low and suppressing the viscosity of the thermally conductive composition to a low level.

As the alkoxysilane compound, one or two or more can be used. Specific examples of the alkoxysilane compound include an alkyl group-containing alkoxysilane compound, a vinyl group-containing alkoxysilane compound, an acryloyl group-containing alkoxysilane compound, a methacryloyl group-containing alkoxysilane compound, an aromatic group-containing alkoxysilane compound, an amino group-containing alkoxysilane compound, an isocyanate group-containing alkoxysilane compound, an isocyanurate group-containing alkoxysilane compound, an epoxy group-containing alkoxysilane compound, and a mercapto group-containing alkoxysilane compound.

Examples of the alkyl group-containing alkoxysilane compound include methyltrimethoxysilane, dimethyldimethoxysilane, trimethylmethoxysilane, methyltriethoxysilane, dimethyldiethoxysilane, ethyltrimethoxysilane, n-propyltrimethoxysilane, n-propyltriethoxysilane, isobutyltrimethoxysilane, isobutyltriethoxysilane, n-hexyltrimethoxysilane, n-

5

hexyltriethoxysilane, cyclohexylmethyldimethoxysilane, n-octyltriethoxysilane, and n-decyltrimethoxysilane. Among the alkyl group-containing alkoxysilane compounds, at least one selected from the group consisting of isobutyltrimethoxysilane, isobutyltriethoxysilane, n-hexyltrimethoxysilane, n-hexyltriethoxysilane, cyclohexylmethyldimethoxysilane, n-octyltriethoxysilane, and n-decyltrimethoxysilane is preferable, at least one selected from the group consisting of n-octyltriethoxysilane and n-decyltrimethoxysilane is more preferable, and n-decyltrimethoxysilane is particularly preferable.

Examples of the vinyl group-containing alkoxysilane compound include vinyltrimethoxysilane and vinyltriethoxysilane. Examples of the acryloyl group-containing alkoxysilane compound include 3-acryloxypropyltrimethoxysilane. Examples of the methacryloyl group-containing alkoxysilane compound include 3-methacryloxypropylmethyldimethoxysilane, 3-methacryloxypropyltrimethoxysilane, and 3-methacryloxypropyltriethoxysilane. Examples of the aromatic group-containing alkoxysilane compound include phenyltrimethoxysilane and phenyltriethoxysilane. Examples of the amino group-containing alkoxysilane compound include N-2-(aminoethyl)-3-aminopropylmethyldimethoxysilane, N-2-(aminoethyl)-3-aminopropyltrimethoxysilane, 3-aminopropyltrimethoxysilane, 3-aminopropyltriethoxysilane, and N-phenyl-3-aminopropyltrimethoxysilane. Examples of the isocyanate group-containing alkoxysilane compound include 3-isocyanatopropyltriethoxysilane. Examples of the isocyanurate group-containing alkoxysilane compound include tris-(trimethoxysilylpropyl)isocyanurate. Examples of the epoxy group-containing alkoxysilane compound include 2-(3,4-epoxycyclohexyl)ethyltrimethoxysilane, 3-glycidoxypropylmethyldimethoxysilane, 3-glycidoxypropyltrimethoxysilane, and 3-glycidoxypropyltriethoxysilane. Examples of the mercapto group-containing alkoxysilane compound include 3-mercaptopropyltrimethoxysilane.

The above specific examples of the alkoxysilane compounds are merely examples, and the alkoxysilane compounds are not limited thereto.

As the volatile solvent, a solvent having a boiling point (1 atm) of 60 to 200°C, preferably a boiling point of 100 to 130°C, can be used. In addition, the volatile solvent preferably has a higher boiling point than the curing temperature of the organopolysiloxane by 10°C or more, and more preferably a higher boiling point by 20°C or more.

As the type of volatile solvent, a solvent satisfying the above requirements can be appropriately selected, and it is preferable to use an aromatic compound such as toluene.

The content of the volatile compound in the liquid composition is preferably 5 to 100 parts by mass and more preferably 15 to 80 parts by mass per 100 parts by mass of the curable silicone composition. When the content of the volatile compound is in the above range, it becomes easy to obtain a thermally conductive sheet having an increased content of the thermally conductive filler.

(Silicone oil)

The liquid composition in the present invention preferably includes a silicone oil from the viewpoint of enhancing the softness of the thermally conductive sheet and the peelability of the gas-permeable film or the like described later. The silicone oil may be a straight silicone oil or a modified silicone oil, and is preferably a straight silicone oil.

Examples of the straight silicone oil include dimethyl silicone oil and methyl phenyl silicone oil. The liquid composition preferably includes at least one of dimethyl silicone oil and methyl phenyl silicone oil, and more preferably includes both.

By containing dimethyl silicone oil in the liquid composition, the softness of the thermally conductive sheet is easily improved. In addition, by containing methyl phenyl silicone oil in the liquid composition, the peelability of the gas-permeable film from the thermally conductive sheet is improved, and in particular, the peelability of a non-porous gas-permeable film formed from poly 4 methylpentene-1 described later is improved. Because of this, the surface condition of the thermally conductive sheet can be prevented from being affected at the time of peeling.

The content of the silicone oil is preferably 5 to 100 parts by mass, preferably 10 to 80 parts by mass, and more preferably 15 to 70 parts by mass per 100 parts by mass of the curable silicone composition.

(Additive components)

The liquid composition may optionally contain an additive. Examples of the additive include at least one or more selected from the group consisting of a dispersant, a coupling agent, a pressure-sensitive adhesive, a flame retardant, an antioxidant, a colorant, an antisettling agent, and the like. In addition, when the curable silicone composition is cured, a curing catalyst or the like that accelerates the curing may be blended as an additive. Examples of the curing catalyst include a platinum-based catalyst.

The liquid composition is prepared by mixing a curable silicone composition, a thermally conductive filler, a volatile compound, and a silicone oil, an additive, and the like to be optionally blended. The liquid composition encompasses one in the form of a slurry having a low viscosity to one in the form of a clay that has a high viscosity and does not flow naturally, and the liquid composition preferably has a fluidity in the range of the puncture load described later. An additive component may optionally be appropriately further mixed into the liquid composition. Here, for mixing each component constituting the liquid composition, for example, a known kneader, kneading roll, mixer, or vibration stirrer may be used.

(Puncture load of liquid composition)

In the liquid composition, the puncture load measured by inserting a puncture rod having a puncture surface having a diameter of 3 mm from the liquid level to a depth of 12 mm is preferably 1 to 20 gf. When the puncture load of the liquid composition is in the above range, the liquid composition can be suitably applied onto a resin sheet and can be formed into a sheet shape. The puncture load of the liquid composition is more preferably 2 to 15 gf and further preferably 5 to 12 gf.

<Step (2)>

The step (2) is a step of sandwiching the liquid composition between two resin sheets at least one of which is a gas-permeable film and pressurizing these to obtain a sheet-shaped formed product.

By using the gas-permeable film, when the curable silicone composition included in the sheet-shaped formed product is heated and cured in the step (3) described later, the volatile compound can be appropriately volatilized, and the generation of an air bubble or the like can be suppressed in the thermally conductive sheet formed from the sheet-shaped formed product. In addition, unevenness is less likely to be formed on the surface of the thermally conductive sheet, and a thermally conductive sheet having a good surface condition can be obtained.

Of the two resin sheets, one may be a low gas-permeable film, and from the viewpoint of easily volatilizing the volatile compound from both sides of the thermally conductive sheet, both the resin sheets of the two resin sheets between which the liquid composition is sandwiched are preferably gas-permeable films.

Here, the gas permeability means the property of a liquid being unable to permeate but a gas being able to permeate, and the oxygen permeability of the gas-permeable film is, for example, $5 \times 10^3$ cm$^3$/(m$^2$●day●MPa) or more. On the other hand, the oxygen permeability of the low gas-permeable film is less than $5.0 \times 10^3$ cm$^3$/m$^2$●day●MPa. Here, the oxygen permeability is measured according to JIS K7126-2.

The oxygen permeability of the gas-permeable film in the present invention is preferably $1.0 \times 10^4$ cm$^3$/m$^2$●day●MPa or more and more preferably $1.5 \times 10^4$ cm$^3$/m$^2$●day●MPa. Then, from the viewpoint of leaving the volatile compound in the thermally conductive sheet to some extent to improve the softness, the oxygen permeability of the gas-permeable film is preferably $1.0 \times 10^6$ cm$^3$/m$^2$●day●MPa or less.

Examples of the gas-permeable film include a porous film and a non-porous gas-permeable film. The porous film is a film having a plurality of pores, and is formed from a mixture of a polymer and a filler, a mixture of polymers, or the like. The non-porous gas-permeable film is a film that has no pores as formed in a porous film and has gas permeability. Among these, the non-porous gas-permeable film is preferable as the gas-permeable film. By using the non-porous gas-permeable film, the surface condition of the thermally conductive sheet formed through the step (3) described later becomes good, the thermal resistance value decreases, and further, the softness also becomes good.

The polymer constituting the gas-permeable film is not particularly limited, and examples thereof include low-density polyethylene, linear low-density polyethylene, poly 4 methylpentene-1, ethyl cellulose, and a fluorine-based resin such as polytetrafluoroethylene or a fluorine-modified resin. Among these, a non-porous gas-permeable film formed from poly 4 methylpentene-1 is preferable. The gas-permeable film formed from poly 4 methylpentene-1 has a moderate thickness and high gas permeability, and thus when the curable silicone composition is cured, the volatile compound can be suitably volatilized, and further, when the gas-permeable film is peeled off from the sheet, the gas-permeable film is excellent in releasability. If a non-porous gas-permeable film formed from poly 4 methylpentene-1 is used, a liquid resin does not penetrate into a pore when the liquid composition is applied, and thus the releasability is particularly excellent, and further, unevenness due to a pore is not formed because of the absence of a pore on the film surface, and a primary sheet having little unevenness and a good surface condition can be obtained.

The gas-permeable film may be a gas-permeable film using the polymer alone, or may be used as a multilayer gas-permeable film obtained by laminating a plurality of resin layers formed from polymers having different gas-permeabilities. In this case, even if a resin other than the above polymer is used, by forming a thin resin layer, a multilayer gas-permeable film having an oxygen permeability of $5.0 \times 10^3$ cm$^3$/m$^2$●day●MPa or more as a whole may be configured.

When the thermally conductive sheet is used, the resin sheet on the surface is peeled off and used, and thus the resin sheet is preferably a release film made of a resin having good releasability or a release film having a release layer on at least one surface thereof.

The thickness of the resin sheet is not particularly limited, and is, for example, 5 to 300 μm, preferably 10 to 250 μm, and more preferably 30 to 200 μm. The thickness may be appropriately adjusted in such a way as to provide the desired oxygen permeability.

In the step (2), the liquid composition obtained in the step (1) is sandwiched between two resin sheets at least one of which is a gas-permeable film and pressurized. The method for sandwiching the liquid composition between two resin sheets is not particularly limited, and examples thereof include a method involving applying the liquid composition onto the surface of one of the two resin sheets and overlaying the other resin sheet on the application side. The means for pressurization is not particularly limited, and the pressurization can be carried out using, for example, a roll or a press. By pressurization, a sheet-shaped formed product sandwiched between two resin sheets can be obtained.

<Step (3)>

The step (3) is a step of heating the sheet-shaped formed product obtained in the step (2) to volatilize at least a part of the volatile compound. In the step (3), a thermally conductive sheet sandwiched between two resin sheets at least one of which is a gas-permeable film is obtained.

By heating the sheet-shaped formed product, a part of the volatile compound is volatilized and the curable silicone composition is cured to obtain a thermally conductive sheet. The sheet-shaped formed product has a gas-permeable film on at least one side thereof, and thus when the curable silicone composition included in the sheet-shaped formed product is heated and cured, the volatile compound can be suitably volatilized, and the generation of an air bubble or the like in the thermally conductive sheet formed from the sheet-shaped formed product can be suppressed.

The thermally conductive sheet produced without volatilizing the volatile compound is too soft to be restorable, resulting in poor handleability and the like. On the other hand, the thermally conductive sheet produced by completely volatilizing the volatile compound has reduced softness.

The amount of the volatile compound volatilized is preferably 5 to 80% by mass and more preferably 7 to 50% by mass when the volatile compound included in the sheet-shaped formed product before volatilization is 100% by mass. By setting the amount of the volatile compound volatilized in the above range, it becomes easy to obtain a thermally conductive sheet having moderate softness and also good handleability.

The amount volatilized can be adjusted by adjusting the heating temperature and the heating time, and the curing rate of the curable silicone composition. The heating temperature may be a temperature of, for example, about 65 to 100°C. In addition, the heating time is, for example, about 2 to 24 hours. By heating, a part of the volatile compound is volatilized and the sheet-shaped formed product is cured to obtain a thermally conductive sheet.

In addition, it is particularly preferable to adjust the heating temperature to a temperature at which 5 to 80% of the amount of the volatile compound added is volatilized at a heating time of 15 hours. By doing so, it is possible to suppress the rapid volatilization of the volatile compound and suppress the air bubble remaining in the sheet. In addition, the heating temperature is preferably a temperature at which the curable silicone composition is not cured rapidly, for example, a temperature at which it takes 1 hour or more, preferably 2 hours or more, and particularly preferably 4 hours or more to be cured. The reason for that is that curing tends to proceed from the surface, and if the curing time is shorter than 1 hour, a skin layer having a high resin concentration is formed on the surface immediately after heating, and there is concern that this skin layer may inhibit volatilization. On the other hand, the curing rate may be any as long as the curing rate provides curing within the heating time. Here, curing shall refer to a state in which the reaction has proceeded to the extent of solidification. In addition, the heating time shall be longer than the curing time.

By heating in the step (3), the alkenyl group-containing organopolysiloxane and the hydrogen organopolysiloxane react with each other to form a crosslinked product of the organopolysiloxane. That is, the thermally conductive sheet obtained in the step (3) is a thermally conductive sheet including a binder which is a crosslinked product of an organopolysiloxane, a thermally conductive filler dispersed in the binder, and a volatile compound.

The thermally conductive sheet is provided with resin sheets on both sides thereof, and thus in the step (3), a laminated body including: a thermally conductive sheet including a binder which is a crosslinked product of an organopolysiloxane, a thermally conductive filler dispersed in the binder, and a volatile liquid; and resin sheets provided on both sides of the thermally conductive sheet is obtained. The thermally conductive sheet can be used by appropriately peeling off the resin sheet(s) of the laminated body.

(Thermal resistance value)

The thermal resistance value of the thermally conductive sheet in the present invention is preferably $0.024°C \bullet in^2/W$ or less, more preferably $0.022°C \bullet in^2/W$ or less, and further preferably $0.020°C \bullet in^2/W$ or less. When the thermal resistance value is such a value, the thermally conductive sheet easily transfers heat from a heating element to a heat-dissipating element. A smaller thermal resistance value is better, and the thermal resistance value is usually $0.001°C \bullet in^2/W$ or more. The thermal resistance value is a thermal resistance value in the thickness direction of the thermally conductive sheet, and is measured by the method described in Examples.

(Type OO hardness)

The type OO hardness of the thermally conductive sheet is, for example, 70 or less. When the thermally conductive sheet has a type OO hardness of 70 or less, the softness is ensured, the conformability to, for example, a heating element and a heat-dissipating element becomes good, and the heat-dissipating property easily becomes good. In addition, from the viewpoint of improving the softness to make the conformability and the like excellent, the type OO hardness of the thermally conductive sheet is preferably 60 or less and more preferably 50 or less.

In addition, the type OO hardness of the thermally conductive sheet is not particularly limited, and is, for example, 15 or more.

[Laminated body]

In the present invention, a laminated body including: a thermally conductive sheet including a binder which is a crosslinked product of an organopolysiloxane, a thermally conductive filler dispersed in the binder, and a volatile compound; and resin sheets provided on both sides of the thermally conductive sheet can also be provided.

The laminated body is provided with resin sheets on both sides of the thermally conductive sheet, and the resin sheets can be appropriately peeled off to use the laminated body as the thermally conductive sheet alone.

The thermally conductive sheet in the laminated body of the present invention includes a crosslinked body of an organopolysiloxane. The organopolysiloxane is formed by reacting an alkenyl group-containing organopolysiloxane and a hydrogen organopolysiloxane.

The thermally conductive sheet in the laminated body of the present invention includes a thermally conductive filler. Because of this, the thermal resistance value of the thermally conductive sheet decreases, and the heat-dissipating property increases. As the thermally conductive filler, the above types can be used without particular limitation.

The content of the thermally conductive filler is preferably in the range of 500 to 6000 parts by mass, more preferably in the range of 1500 to 5000 parts by mass, and further preferably in the range of 2500 to 4500 parts by mass per 100 parts by mass of the binder. When the amount of the thermally conductive filler is equal to or more than these lower limit values, the thermal resistance value of the thermally conductive sheet decreases and the heat-dissipating property increases, and when the amount of the thermally conductive filler is equal to or less than these upper limit values, the viscosity of the liquid composition which is a raw material of the thermally conductive sheet decreases, providing a thermally conductive sheet having a good surface condition.

Even if the content of the thermally conductive filler is increased, the thermally conductive sheet in the present invention can be formed into a sheet, and the softness can also be secured. In addition, even if the thickness of the thermally conductive sheet is relatively thick, the content of the thermally conductive filler can be increased while maintaining the softness, and thus the thermal resistance value can be lowered.

The thermally conductive sheet in the laminated body of the present invention includes a volatile compound, which increases the softness of the thermally conductive sheet. As the volatile compound, the above types can be used without particular limitation.

The content of the volatile compound is preferably 2.5 to 90 parts by mass and more preferably 8 to 70 parts by mass per 100 parts by mass of the binder. When the content of the volatile compound is in these ranges, the softness of the thermally conductive sheet easily increases.

The residual amount of the volatile compound in the thermally conductive sheet is preferably 10 to 90% by mass, more preferably 20 to 90% by mass, and further preferably 30 to 85%. When the residual amount of the volatile compound is in these ranges, the softness of the thermally conductive sheet easily increases. The residual amount of the volatile compound means the amount (% by mass) of the volatile compound remaining in the thermally conductive sheet when the amount of the volatile compound blended in the liquid composition which is a raw material for forming the thermally conductive sheet is 100% by mass.

In the laminated body of the present invention, resin sheets are provided on both sides of the thermally conductive sheet. The resin sheet may be a gas-permeable film or a low gas-permeable film. When the thermally conductive sheet is used, the resin sheet is peeled off from the laminated body, and thus the resin sheet is preferably a release film having a release layer on one or both sides thereof.

The types of the resin sheets on both sides may be the same or different.

Of the resin sheets, the resin sheet provided on at least one side is preferably a gas-permeable film. Such an embodiment makes it easy to obtain a thermally conductive sheet that is soft, has a good surface condition, and has a low thermal resistance value when the laminated body is produced. From the viewpoint of easily obtaining a thermally conductive sheet that is soft and has a low thermal resistance value, the resin sheets on both sides of the thermally conductive sheet are preferably both gas-permeable films. As the gas-permeable film, those described above can be used, and a non-porous gas-permeable film is particularly preferable.

The thickness of the gas-permeable film is not particularly limited, and is, for example, 5 to 300 $\mu$m, preferably

10 to 250 $\mu$m, and more preferably 30 to 200 $\mu$m. The thickness may be appropriately adjusted in such a way as to provide the desired oxygen permeability.

The method for producing a laminated body in which the resin sheet provided on at least one side of the thermally conductive sheet is a gas-permeable film as described above is not particularly limited, and the laminated body is preferably produced through the above steps (1) to (3).

In the laminated body of the present invention, the resin sheets provided on both sides of the thermally conductive sheet are also preferably both low gas-permeable films. With the laminated body of such an embodiment, it is possible to suppress reduction in the amount of the volatile compound included in the thermally conductive sheet due to vaporization or the like during the storage of the laminated body. Because of this, it is possible to prevent a change in a physical property such as the softness of the thermally conductive sheet.

The thickness of the low gas-permeable film is not particularly limited, and is, for example, 5 to 300 $\mu$m, preferably 10 to 250 $\mu$m, and more preferably 30 to 200 $\mu$m. The thickness may be appropriately adjusted in such a way as to provide the desired oxygen permeability.

The method for producing a laminated body in which the resin sheets provided on both sides of the thermally conductive sheet are both low gas-permeable films is not particularly limited, and such a laminated body can be produced by producing a laminated body through the above steps (1) to (3) and replacing each of the gas-permeable films of this laminated body with a low gas-permeable film. That is, examples of the method include a method for producing a laminated body wherein by the above steps (1), step (2), and step (3), a thermally conductive sheet sandwiched between two resin sheets at least one of which is a gas-permeable film is obtained, and then a step (4) of peeling off the gas-permeable film of the thermally conductive sheet and a step (5) of laminating a low gas-permeable film on a side from which the gas-permeable film has been peeled off are carried out.

In addition, as another method, it is also possible to configure as a multilayer, low gas-permeable film having reduced gas permeability as a laminated body by further laminating a low gas-permeable film on the gas-permeable film. That is, examples of the method include a method for producing a laminated body wherein by the above steps (1), step (2), and step (3), a thermally conductive sheet sandwiched between two resin sheets at least one of which is a gas-permeable film is obtained, and then a step (5') of laminating a low gas-permeable film on the gas-permeable film is carried out.

As the low gas-permeable film, for example, those described above can be used.

The thermally conductive sheet can be used by appropriately peeling off the resin sheets provided on both sides of the laminated body. The thickness of the thermally conductive sheet in the present invention may be appropriately selected depending on the shape and application of the electronic device on which the sheet is mounted, and is preferably 100 to 5000 $\mu$m, more preferably 500 to 4000 $\mu$m, and further preferably 1000 to 3000 $\mu$m. The thermally conductive sheet of the present invention can have a thermal resistance value of a certain level or less even if the thermally conductive sheet has a thickness in such a thickness range.

The thermally conductive sheet is used inside an electronic device or the like. Specifically, the thermally conductive sheet is interposed between a heating element and a heat-dissipating element, conducts heat generated by the heating element, and transfers the heat to the heat-dissipating element to dissipate the heat from the heat-dissipating element. Here, examples of the heating element include various electronic parts such as a CPU, a power amplifier, and a power supply such as a battery used inside an electronic device. In addition, examples of the heat-dissipating element include a heat sink, a heat pipe, a heat pump, and a metal housing of an electronic device. The thermally conductive sheet is used by causing both surfaces to be in close contact with the heating element and the heat-dissipating element, respectively, and being compressed.

Examples

Hereinafter, the present invention will be described in more detail with reference to Examples, but the present invention is not limited to these Examples at all.

In the present Examples, evaluations were made by the following method.

[Puncture load]

The liquid composition was defoamed and next, 30 g of the liquid composition was introduced into a cylindrical container having a diameter of 25 mm. Next, a puncture rod having a disk-shaped puncture surface having a diameter of 3 mm at the tip was pressed against the liquid composition introduced into the container from the tip side of the puncture rod at a rate of 10 mm/min, and the load (gf) when the tip of the puncture rod reached a depth of 12 mm below the liquid level was measured. The measurement was carried out at 25°C.

[O hardness]

The type OO hardness of the thermally conductive sheet was measured using a type OO durometer.

[Weight loss A]

About 40 g of the liquid composition was discharged onto a resin sheet on the lower side weighed, sandwiched between the resin sheet on the lower side and a resin sheet on the upper side weighed, and then the composition was spread using a press to a thickness of 2 mm to produce a sample. As the liquid composition, the liquid composition of the formulation used in each of the Examples and the Comparative Examples was used. The weight of the sample was measured in that state, and then the sample was heated and cured in a constant temperature bath under predetermined conditions (heating temperature of 80°C, heating time of 15 hours). At this time, the sample was placed on a net-shaped rack so that volatilization was also possible from the lower resin sheet side. Next, the difference in weight (amount of weight loss A) between the sample before heating and the sample after heating was calculated.

The weight loss A (%) was calculated by the following expression.

$$\text{Weight loss A (\%)} = [\text{amount of weight loss A/amount of liquid composition before curing}] \times 100$$

[Amount volatilized]

The amount of the volatile liquid volatilized was calculated from the amount of weight loss A. The amount volatilized means the amount (% by mass) of the volatile compound volatilized by heating when the amount of the volatile compound before heating is 100% by mass.

[Weight loss B]

For the thermally conductive sheet having a thickness of 2 mm produced under the conditions described in each of the Examples and the Comparative Examples described later, a test sample having an area corresponding to a weight of 40 g was provided. The remaining volatile liquid was volatilized by heating this sample in a constant temperature bath under predetermined conditions (heating temperature of 150°C, heating time of 250 hours). At this time, the sample was placed on a net-shaped rack so that volatilization was also possible from the lower side. Next, the difference in weight (amount of weight loss B) between the sample before heating and the sample after heating was calculated.

The weight loss B (%) was calculated by the following expression.

$$\text{Weight loss B (\%)} = [\text{amount of weight loss B/weight of sample before heating}] \times 100$$

[Residual amount]

The residual amount of the volatile liquid remaining in the thermally conductive sheet was calculated from the amount of weight loss B. The residual amount means the amount (% by mass) of the volatile compound remaining in the thermally conductive sheet when the amount of the volatile compound blended is 100% by mass.

[Thermal resistance value]

The thermal resistance value was measured using a thermal resistance measuring instrument as shown in Fig. 1 by the method shown below.

Specifically, for each sample, a test piece S having a size of 30 mm × 30 mm × 2 mmt was produced for the present test. Then, each test piece S was attached onto a copper block 22 having a measurement surface of 25.4 mm × 25.4 mm and having a side surface covered with a thermal insulator 21 and sandwiched between the copper block 22 and an upper copper block 23, and a load of 60 psi was applied using a load cell 26 so that the thickness was set to be 50% of the original thickness using a 1 mm spacer. Here, the lower copper block 22 is in contact with a heater 24. In addition, the upper copper block 23 is covered with the thermal insulator 21 and connected to a heat sink 25 with a fan. Next, the heater 24 was caused to generate heat at an amount of heat generated of 25 W, and 10 minutes after the temperature became in a substantially steady state, the temperature of the upper copper block 23 ($\theta_{j0}$), the temperature of the lower copper block 22 ($\theta_{j1}$), and the amount of heat generated of the heater (Q) were measured, and the thermal resistance value of each sample was determined from the following expression (1).

$$\text{Thermal resistance} = (\theta_{j1} - \theta_{j0})/Q \ldots \text{Expression (1)}$$

In the expression (1), $\theta_{j1}$ is the temperature of the lower copper block 22, $\theta_{j0}$ is the temperature of the upper copper block 23, and Q is the amount of heat generated.

[Sheet condition]

A ... The softness of the whole sheet was good, and no air bubble was found
B ... The softness of both sides were different and physical properties were not uniform, but no air bubble was found
C ... The whole sheet was hard, but no air bubble was found
D ... An air bubble was generated at the boundary between the resin sheet and the thermally conductive sheet

The following components were used to produce the thermally conductive sheets.

(Curable silicone composition)

A curable silicone composition including an alkenyl group-containing organopolysiloxane and a hydrogen organopolysiloxane. Specific gravity of curable silicone composition of 0.97

(Thermally conductive filler)

Aluminum oxide 1 ... Average particle size of 0.5 $\mu$m, specific gravity of 3.9
Aluminum oxide 2 ... Average particle size of 3 $\mu$m, specific gravity of 3.9
Aluminum oxide 3 ... Average particle size of 40 $\mu$m, specific gravity of 3.9
Aluminum oxide 4 ... Average particle size of 70 $\mu$m, specific gravity of 3.9
Aluminum nitride 1 ... Average particle size of 30 $\mu$m, specific gravity of 3.3
Aluminum nitride 2 ... Average particle size of 50 $\mu$m, specific gravity of 3.3
Aluminum nitride 3 ... Average particle size of 80 $\mu$m, specific gravity of 3.3

(Volatile compound)

n-Decyltrimethoxysilane ... The temperature T1 at which the weight loss when the temperature is raised under a condition of 2°C/min in thermogravimetric analysis is 90% is 187°C, specific gravity of 0.9

(Silicone oils)

Dimethyl silicone, specific gravity of 0.96
Methyl phenyl silicone, specific gravity of 1.07, refractive index of 1.49

(Resin sheets)

A. Gas-permeable films

Non-porous gas-permeable film 1, "Opulent" CR1012 MT4 #150 manufactured by Mitsui Chemicals, Inc. oxygen permeability of 19000 $cm^3/m^2 \bullet day \bullet MPa$, thickness of 150 $\mu$m multilayer type (embossed)

Non-porous gas-permeable film 2, "Opulent" CR2031 MT4 #120 manufactured by Mitsui Chemicals, Inc. oxygen permeability of 23500 cm$^3$/m$^2$●day●MPa, thickness of 120 $\mu$m multilayer type (embossed)

Non-porous gas-permeable film 3, "Opulent" X-88B MT4 #100 manufactured by Mitsui Chemicals, Inc. oxygen permeability of 140000 cm$^3$/m$^2$●day●MPa, thickness of 50 $\mu$m single-layer type (embossed)

Non-porous gas-permeable film 4, "Opulent" X-88B #100 manufactured by Mitsui Chemicals, Inc. oxygen permeability of 140000 cm$^3$/m$^2$●day●MPa, thickness of 50 $\mu$m single-layer type (glossed)

Porous film 1, "Tyvek" manufactured by DuPont, oxygen permeability 10000000 cm$^3$/m$^2$●day●MPa or more

B. Low gas-permeable film

PET film with fluorine-based release layer thickness of 100 $\mu$m, oxygen permeability of 1000 cm$^3$/m$^2$●day●MPa

[Preparation of liquid composition (formulation 1)]

A total of 70 parts by mass of an alkenyl group-containing organopolysiloxane and a hydrogen organopolysiloxane as the curable silicone composition, 44 parts by mass of dimethyl silicone, 20 parts by mass of methyl phenyl silicone, 10 parts by mass of n-decyltrimethoxysilane, 228 parts by mass of aluminum oxide 1, 842 parts by mass of aluminum oxide 2, 664 parts by mass of aluminum oxide 3, and 996 parts by mass of aluminum oxide 4 were mixed to obtain a liquid composition of formulation 1.

[Preparation of liquid composition (formulation 2)]

Liquid compositions of formulations 2 to 8 were obtained in the same manner as in formulation 1 except that the type and amount of each component were changed as shown in Table 1. The liquid compositions of formulations 7 and 8 were in the form of a powder and were unable to be formed into a sheet.

When the curability of formulation 1 to formulation 6 was checked, it was found that these were solidified when heated at 80°C for 5 hours.

Table 1

| | | Formulation 1 | Formulation 2 | Formulation 3 | Formulation 4 | Formulation 5 | Formulation 6 | Formulation 7 | Formulation 8 |
|---|---|---|---|---|---|---|---|---|---|
| Liquid composition (parts by mass) | Curable silicone composition | 70 | 70 | 70 | 70 | 70 | 70 | 70 | 70 |
| | Dimethyl silicone | 44 | 44 | 44 | | | | 44 | |
| | Methyl phenyl silicone | 20 | 20 | 20 | 30 | 30 | 30 | 20 | 30 |
| | n-Decyltrimethoxysilane | 10 | 14 | 21 | 35.7 | 45 | 49.9 | 0 | 0 |
| | Aluminum oxide 1:0.5 $\mu$m | 228 | 228 | 228 | 228 | 228 | 228 | 228 | 228 |
| | Aluminum oxide 2:3 $\mu$m | 842 | 842 | 842 | 702 | 702 | 702 | 842 | 702 |
| | Aluminum oxide 3:40 $\mu$m | 664 | 664 | 664 | | | | 664 | |
| | Aluminum oxide 4:70 $\mu$m | 996 | 996 | 996 | | | | 996 | |
| | Aluminum nitride 1:30 $\mu$m | | | | 140 | 140 | 140 | | 140 |
| | Aluminum nitride 2:50 $\mu$m | | | | 421 | 421 | 421 | | 421 |
| | Aluminum nitride 3:80 $\mu$m | | | | 842 | 842 | 842 | | 842 |
| Puncture load [gf] | | 9.2 | 7.5 | 5.6 | 10.6 | 7.6 | 6.2 | - | - |

EP 4 159 433 A1

14

[Example 1]

The liquid composition of formulation 1 was discharged onto a resin sheet on the lower side (Opulent CR1012) and sandwiched between the resin sheet on the lower side and a resin sheet on the upper side (Opulent CR1012), and then the composition was spread using a press to produce a sheet-shaped formed product.

Then, the sheet-shaped formed product was heated at 80°C for 15 hours in a state in which the sheet-shaped formed product was sandwiched between the two resin sheets to cure the curable silicone composition included in the sheet-shaped formed product while volatilizing a part of the volatile compound, to obtain a thermally conductive sheet having a thickness of 2 mm.

[Examples 2 to 16 and Comparative Examples 1 to 6]

Thermally conductive sheets having a thickness of 2 mm were obtained in the same manner as in Example 1 except that the type of the formulation of the liquid composition and the types of the resin sheets were changed as shown in Tables 2 and 3.

Table 2

| | | Example 1 | Example 2 | Example 3 | Example 4 | Example 5 | Example 6 | Example 7 | Example 8 | Comparative Example 1 | Comparative Example 2 | Comparative Example 3 |
|---|---|---|---|---|---|---|---|---|---|---|---|---|
| Liquid composition formulation | | Formulation 1 | Formulation 1 | Formulation 1 | Formulation 1 | Formulation 1 | Formulation 1 | Formulation 2 | Formulation 3 | Formulation 1 | Formulation 2 | Formulation 3 |
| Resin sheets | PET film with fluorine-based release layer | | | | | | Lower side | | | Both sides | Both sides | Both sides |
| | Opulent CR1012 MT4 #150 | Both sides | | | | | Upper side | Both sides | Both sides | | | |
| | Opulent CR2031 MT4 #120 | | Both sides | | | | | | | | | |
| | Opulent X-88B MT4 #100 | | | Both sides | | | | | | | | |
| | Opulent X-88B #100 | | | | Both sides | | | | | | | |
| | Tyvek 1442R | | | | | Both sides | | | | | | |
| | Oxygen permeability (cm$^3$/m$^2$·day·MPa) | $1.9 \times 10^4$ | $2.4 \times 10^4$ | $1.4 \times 10^5$ | $1.4 \times 10^5$ | $>10^7$ | $1.0 \times 10^4$ | $1.9 \times 10^4$ | $1.9 \times 10^4$ | $1.0 \times 10^3$ | $1.0 \times 10^3$ | $1.0 \times 10^3$ |

EP 4 159 433 A1

(continued)

| | | Example 1 | Example 2 | Example 3 | Example 4 | Example 5 | Example 6 | Example 7 | Example 8 | Comparative Example 1 | Comparative Example 2 | Comparative Example 3 |
|---|---|---|---|---|---|---|---|---|---|---|---|---|
| Liquid composition formulation | | Formulation 1 | Formulation 1 | Formulation 1 | Formulation 1 | Formulation 1 | Formulation 1 | Formulation 2 | Formulation 3 | Formulation 1 | Formulation 2 | Formulation 3 |
| Evaluations of thermally conductive sheet | Sheet condition | A | A | A | A | C | B | A | A | D | D | D |
| | O hardness | 61 | 60 | 61 | 54 | 82 | 62 | 51 | 41 | 63 | 55 | 45 |
| | Specific gravity | 3.41 | 3.41 | 3.41 | 3.42 | 3.53 | 3.41 | 3.41 | 3.40 | 3.41 | 3.40 | 3.39 |
| | Weight loss A (%) | 0.047 | 0.029 | 0.025 | 0.032 | 0.174 | 0.036 | 0.077 | 0.127 | 0.012 | 0.022 | 0.031 |
| | Amount volatilized (%) | 13.4 | 8.2 | 7.3 | 9.1 | 49.9 | 10.4 | 15.8 | 17.4 | 3.4 | 3.7 | 4.3 |
| | Weight loss B (%) | 0.268 | 0.285 | 0.292 | 0.288 | 0.096 | 0.291 | 0.268 | 0.255 | 0.331 | 0.564 | 0.689 |
| | Residual amount (%) | 77.0 | 81.9 | 83.9 | 82.8 | 27.6 | 83.6 | 55.0 | 35.0 | 95.1 | 96.1 | 94.6 |
| | Thermal resistance value ($°C \cdot in^2/W$) | 0.169 | 0.169 | 0.167 | 0.174 | 0.228 | 0.181 | 0.166 | 0.165 | 0.238 | 0.245 | 0.248 |

Table 3

| | | Example 9 | Example 10 | Example 11 | Example 12 | Example 13 | Example 14 | Example 15 | Example 16 | Comparative Example 4 | Comparative Example 5 | Comparative Example 6 |
|---|---|---|---|---|---|---|---|---|---|---|---|---|
| Liquid composition formulation | | Formulation 5 | Formulation 5 | Formulation 5 | Formulation 5 | Formulation 5 | Formulation 5 | Formulation 4 | Formulation 6 | Formulation 5 | Formulation 4 | Formulation 6 |
| Resin sheets | PET film with fluorine-based release layer | | | | | | Lower side | | | Both sides | Both sides | Both sides |
| | Opulent CR1012 MT4 #150 | Both sides | | | | | Upper side | Both sides | Both sides | | | |
| | Opulent CR2031 MT4 #120 | | Both sides | | | | | | | | | |
| | Opulent X-88B MT4 #100 | | | Both sides | | | | | | | | |
| | Opulent X-88B #100 | | | | Both sides | | | | | | | |
| | Tyvek 1442R | | | | | Both sides | | | | | | |
| | Oxygen permeability (cm$^3$/m$^2$·day·MPa) | $1.9 \times 10^4$ | $2.4 \times 10^4$ | $1.4 \times 10^5$ | $1.4 \times 10^5$ | $>10^7$ | $1.0 \times 10^4$ | $1.9 \times 10^4$ | $1.9 \times 10^4$ | $1.0 \times 10^3$ | $1.0 \times 10^3$ | $1.0 \times 10^3$ |

18

(continued)

| | | Example 9 | Example 10 | Example 11 | Example 12 | Example 13 | Example 14 | Example 15 | Example 16 | Comparative Example 4 | Comparative Example 5 | Comparative Example 6 |
|---|---|---|---|---|---|---|---|---|---|---|---|---|
| Liquid composition formulation | | Formulation 5 | Formulation 5 | Formulation 5 | Formulation 5 | Formulation 5 | Formulation 5 | Formulation 4 | Formulation 6 | Formulation 5 | Formulation 4 | Formulation 6 |
| Evaluations of thermally conductive sheet | Sheet condition | A | A | A | A | C | B | A | A | D | D | D |
| | O hardness | 66 | 37 | 45 | 55 | Equal to or more than upper limit | 42 | 64 | 52 | 19 | 35 | Less than lower limit |
| | Specific gravity | 3.12 | 3.09 | 3.08 | 3.09 | 3.17 | 3.08 | 3.12 | 3.12 | 3.08 | 3.11 | 3.06 |
| | Weight loss A (%) | 0.695 | 0.581 | 0.542 | 0.532 | 1.095 | 0.576 | 0.528 | 0.879 | 0.016 | 0.022 | 0.028 |
| | Amount volatilized (%) | 38.2 | 31.9 | 29.8 | 29.3 | 60.2 | 31.6 | 36.4 | 43.7 | 0.9 | 1.5 | 1.4 |
| | Weight loss B (%) | 1.081 | 1.185 | 1.250 | 1.262 | 0.410 | 1.212 | 0.875 | 1.122 | 1.801 | 1.425 | 1.952 |
| | Residual amount (%) | 59.4 | 65.1 | 68.7 | 69.3 | 22.5 | 66.6 | 60.3 | 55.8 | 99.0 | 98.3 | 97.1 |
| | Thermal resistance value (°C·in$^2$/W) | 0.184 | 0.184 | 0.179 | 0.184 | 0.212 | 0.191 | 0.164 | 0.183 | 0.203 | 0.201 | 0.216 |

The liquid compositions of formulations 1 to 6 contained a curable silicone composition, a thermally conductive filler, and a volatile liquid and were able to be formed into a sheet, but the compositions of formulations 7 and 8 did not contain a volatile liquid, and it was difficult to form these into a sheet.

Examples 1 to 16 are examples in which a gas-permeable film was used as at least one of the resin sheets on both sides to produce a thermally conductive sheet, and it was found that these had a good sheet condition and a low thermal resistance value. On the other hand, Comparative Examples 1 to 6 were examples in which a low gas-permeable film was used as each of the resin sheets on both sides, and it was found that these had a poor sheet condition and a high thermal resistance value.

In addition, by comparison of Examples 1 and 6 or comparison of Examples 9 and 14, it was found that use of a gas-permeable film on each of both sides provided a better sheet condition and a lower thermal resistance value than use of a gas-permeable film on only one side.

Further, by comparison of Examples 1 to 4 with Example 5 or comparison of Examples 9 to 12 with Example 13, it was found that use of a non-porous gas-permeable film as the gas-permeable film provided a better sheet condition and a lower thermal resistance value than use of a porous film.

The thermally conductive sheets of Example 5 and Example 13 had a high hardness. Because of this, it was found that these had a good sheet condition, but were unable to be compressed to 50% in a thermal resistance test and had a slightly poor thermal resistance value. In addition, when the weights of the post-test resin sheets used in a test of weight loss A were measured, it was found that 0.89% of the mass penetrated in Example 5 (formulation 1). From this, it was found that 18% of the mass based on the mass of the liquid components (curable silicone composition, silicone oil, volatile liquid) penetrated the resin sheets. In addition, it was found that 1.14% of the mass penetrated in Example 13 (formulation 5). From this, it was found that 19% of the mass based on the mass of the liquid components (curable silicone composition, silicone oil, volatile liquid) penetrated the resin sheets.

Reference Signs List

21 Thermal insulator
22 Lower copper block
23 Upper copper block
24 Heater
25 Heat sink
26 Load cell
S Test piece
$\theta_{j0}$ Temperature of upper copper block
$\theta_{j1}$ Temperature of lower copper block

**Claims**

1. A method for producing a thermally conductive sheet, comprising:

   a step (1) of obtaining a liquid composition comprising a curable silicone composition comprising an alkenyl group-containing organopolysiloxane and a hydrogen organopolysiloxane, a thermally conductive filler, and a volatile compound;
   a step (2) of sandwiching the liquid composition between two resin sheets at least one of which is a gas-permeable film and pressurizing these to obtain a sheet-shaped formed product; and
   a step (3) of heating the sheet-shaped formed product to volatilize at least a part of the volatile compound.

2. The method for producing a thermally conductive sheet according to claim 1, wherein in the liquid composition, a puncture load measured by inserting a puncture rod having a puncture surface having a diameter of 3 mm from a liquid level to a depth of 12 mm is 1 to 20 gf.

3. The method for producing a thermally conductive sheet according to claim 1 or 2, wherein the gas-permeable film is a non-porous gas-permeable film.

4. A method for producing a laminated body, wherein

by a step (1) of obtaining a liquid composition comprising a curable silicone composition comprising an alkenyl group-containing organopolysiloxane and a hydrogen organopolysiloxane, a thermally conductive filler, and a volatile compound,

a step (2) of sandwiching the liquid composition between two resin sheets at least one of which is a gas-permeable film and pressurizing these to obtain a sheet-shaped formed product, and

a step (3) of heating the sheet-shaped formed product to volatilize at least a part of the volatile compound, a thermally conductive sheet sandwiched between the two resin sheets at least one of which is a gas-permeable film is obtained, and then

a step (4) of peeling off the gas-permeable film of the thermally conductive sheet and

a step (5) of laminating a low gas-permeable film on a side from which the gas-permeable film has been peeled off are carried out.

5. A method for producing a laminated body, wherein

by a step (1) of obtaining a liquid composition comprising a curable silicone composition comprising an alkenyl group-containing organopolysiloxane and a hydrogen organopolysiloxane, a thermally conductive filler, and a volatile compound,

a step (2) of sandwiching the liquid composition between two resin sheets at least one of which is a gas-permeable film and pressurizing these to obtain a sheet-shaped formed product, and

a step (3) of heating the sheet-shaped formed product to volatilize at least a part of the volatile compound, a thermally conductive sheet sandwiched between the two resin sheets at least one of which is a gas-permeable film is obtained, and then

a step (5') of laminating a low gas-permeable film on the gas-permeable film is carried out.

6. A laminated body comprising: a thermally conductive sheet comprising a binder which is a crosslinked product of an organopolysiloxane, a thermally conductive filler dispersed in the binder, and a volatile compound; and resin sheets provided on both sides of the thermally conductive sheet.

7. The laminated body according to claim 6, wherein of the resin sheets provided on both sides of the thermally conductive sheet, the resin sheet provided on at least one side is a gas-permeable film.

8. The laminated body according to claim 6, wherein the resin sheets provided on both sides of the thermally conductive sheet are both low gas-permeable films.

Fig. 1

## INTERNATIONAL SEARCH REPORT

International application No.

PCT/JP2021/020298

### A. CLASSIFICATION OF SUBJECT MATTER

B32B 27/00(2006.01)i; B32B 27/20(2006.01)i; H01L 23/36(2006.01)i; H01L 23/373(2006.01)i; C08L 83/05(2006.01)i; C08L 83/07(2006.01)i; C08J 5/18(2006.01)i; B29C 43/20(2006.01)i; B29C 43/34(2006.01)i; C08K 3/01(2018.01)i; B32B 7/027(2019.01)i; H05K 7/20(2006.01)i
FI: H01L23/36 D; B29C43/34; H05K7/20 F; B32B27/20 Z; B32B27/00 101; B32B7/027; H01L23/36 M; C08L83/05; C08K3/01; B29C43/20; C08J5/18 CFH; C08L83/07

According to International Patent Classification (IPC) or to both national classification and IPC

### B. FIELDS SEARCHED

Minimum documentation searched (classification system followed by classification symbols)
B32B27/00; B32B27/20; H01L23/36; H01L23/373; C08L83/05; C08L83/07; C08J5/18; B29C43/20; B29C43/34; C08K3/01; B32B7/027; H05K7/20

Documentation searched other than minimum documentation to the extent that such documents are included in the fields searched
Published examined utility model applications of Japan 1922–1996
Published unexamined utility model applications of Japan 1971–2021
Registered utility model specifications of Japan 1996–2021
Published registered utility model applications of Japan 1994–2021

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | WO 2019/160004 A1 (SEKISUI POLYMATECH CO., LTD.) 22 August 2019 (2019-08-22) paragraphs [0011]-[0108] | 6, 8 |
| A | | 1-5, 7 |
| A | WO 2020/105601 A1 (SEKISUI POLYMATECH CO., LTD.) 28 May 2020 (2020-05-28) paragraphs [0012]-[0084], fig. 1-3 | 1-5, 7 |

☐ Further documents are listed in the continuation of Box C.   ☒ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 03 August 2021 (03.08.2021) | 10 August 2021 (10.08.2021) |

| Name and mailing address of the ISA/ | Authorized officer |
|---|---|
| Japan Patent Office 3-4-3, Kasumigaseki, Chiyoda-ku, Tokyo 100-8915, Japan | |
| | Telephone No. |

Form PCT/ISA/210 (second sheet) (January 2015)

**INTERNATIONAL SEARCH REPORT**
Information on patent family members

| International application no. |
| --- |
| PCT/JP2021/020298 |

| Patent Documents referred in the Report | Publication Date | Patent Family | Publication Date |
| --- | --- | --- | --- |
| WO 2019/160004 A1 | 22 Aug. 2019 | TW 201936886 A | |
| WO 2020/105601 A1 | 28 May 2020 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2019150944 A